# EUROPEAN PATENT SPECIFICATION

(11) **EP 0 504 974 B1**
(45) Date of publication and mention of the grant of the patent: **06.09.1995**
(21) Application number: 92200678.8
(22) Date of filing: 11.03.1992
(51) Int. Cl.: H01L 31/02, G05F 1/567

(54) **Electrical supply circuit, in particular for APDs**
Elektrische Versorgungsschaltung, insbesondere für Lawinen-Photodioden
Circuit d'alimentation électrique notamment pour des photodiodes à avalanche

(30) Priority: 18.03.1991 NL 9100476
(43) Date of publication of application: 23.09.1992
(73) Proprietor: Koninklijke PTT Nederland N.V., 2509 CH Den Haag (NL)
(72) Inventor: Tan, Han Hiong, NL-2651 VD Berkel en Rodenrijs (NL)

(56) References cited:
- DE-A- 3 640 242
- PATENT ABSTRACTS OF JAPAN vol. 9, no. 244 (E-346)(1967) 30 September 1985 ; & JP-A-60 094 511
- PATENT ABSTRACTS OF JAPAN vol. 13, no. 374 (E-808)(3722) 18 August 1989 ; & JP-A-1 126 032
- PATENT ABSTRACTS OF JAPAN vol. 12, no. 465 (E-690)(3312) 7 December 1988 ; & JP-A-63 187 672

## Description

### A. BACKGROUND OF THE INVENTION

### 1. Field of the invention

The invention relates to an electrical supply circuit, in particular for supplying an 'Avalanche Photo-Diode' (APD), but which can also be used more generally.

### 2. Prior Art

'Avalanche Photodiodes' (APDs) are diodes which are used as electro-optical converters especially in optical signal transmission engineering. Diodes of this type only give an optimum optical-electrical conversion ('gain') of an optical input signal if the applied diode voltage approaches the breakdown voltage very closely. One problem in this connection is that the breakdown voltage is temperature-dependent, as a result of which, if the applied voltage were to be kept constant, on the one hand, said voltage would not approach the breakdown voltage closely enough, as a result of which the output signal of the diode would be inadequate, or on the other hand, the diode would breakdown in the event of any - unavoidable - increase in the (ambient) temperature.

To eliminate the problem posed, supply circuits for APDs are known whose output voltage has a specified temperature dependence which is matched as well as possible to the temperature dependence of the APD used. Thus, the Japanese patent application JP 60-180,347 discloses such as circuit. However, said circuit has the disadvantage that the level of output voltage and the degree of temperature dependence cannot be controlled independently of one another, which does not, however, have to be a drawback if the circuit is intended solely to supply a specified type of APD; the values of the components can then adjusted by making allowance for said type of APD. At the same time, however, no allowance can be made for specimen variations within the same type of APD. As a consequence thereof, the 'gain' of the APD cannot be optimised, and in practice this nevertheless signifies a loss which cannot be neglected.

A APD bias voltage generating circuit using two differential amplifiers is known from JP-A-60094511.

### B. Summary of the invention

The invention provides a supply circuit which can be used, in particular, to supply APDs which, in contrast to known similar circuits, provide means for the optimum adjustment of both the temperature-independent part of the supply voltage and of the temperature-dependent part thereof, in particular the degree of temperature dependence.

The invention is characterised by a first, temperature-independent voltage source (VS1) whose output voltage (U1) is constant and which is connected to the input of a first voltage amplifier (A1) having a controllable gain (a1), and in addition, by a second, temperature-dependent voltage source (VS2) whose output voltage (U2) is essentially equal to the mathematical product of a constant (C) and the temperature (t) measured at a measuring point and which is connected to the input of a second voltage amplifier (A2) having a controllable gain (a2), the output voltage of the first voltage amplifier and the output voltage of the second voltage amplifier being added to one another. According to the invention, the temperature-independent component and the temperature-dependent component of the supply voltage (quiescent voltage) to be applied to an APD are generated independently of one another by the voltage sources mentioned and the output voltages of said voltage sources are, in addition, adjustable independently of one another by means of the two amplifiers mentioned; the level of the voltage is regulated by means of the first amplifier and the voltage/temperature ratio by means of the second amplifier. These measures make it possible for any APD to be adjusted extremely delicately and, consequently, optimally without, at any temperature whatsoever, either the difference between the supply voltage and the breakdown voltage becoming too large (resulting in a lower 'gain') or the supply voltage being able to exceed the breakdown voltage (with the APD becoming inoperative as a result).

A preferred embodiment of the invention is characterised in that the second, temperature-dependent voltage source mentioned is formed by a third, temperature-independent voltage source (VS3) with a third, constant output voltage (U3) and by a series circuit of a current source and a temperature-dependent impedance(D), the third output voltage mentioned being equal to the voltage (U4) generated by the current source (CS) mentioned across the impedance and being subtracted therefrom, the impedance mentioned preferably being formed by a semiconductor diode connected in the forward direction.

### C. Exemplary embodiment

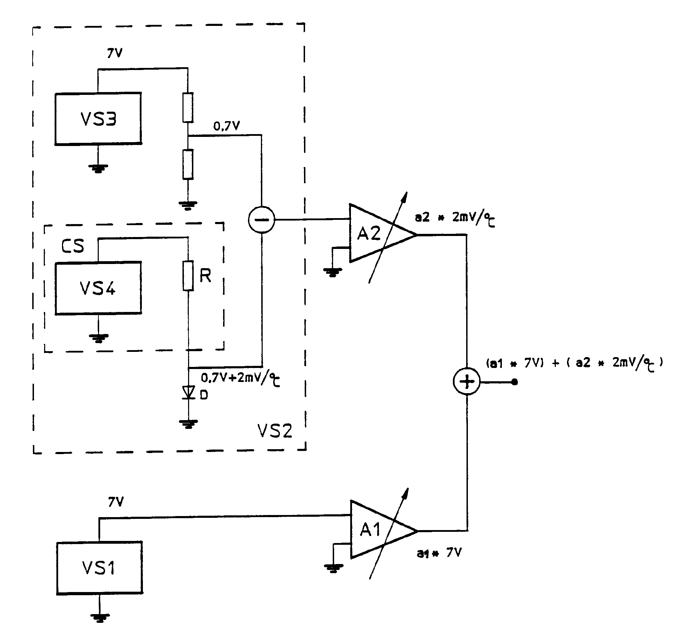

The figure shows an exemplary embodiment of the invention.

The temperature-independent voltage source VS1 mentioned above is formed by a commercially available component such as the type µA723 whose (very stable) output voltage U1 is approximately 7 volts. This voltage source VS1 is connected to an input terminal of a controllable voltage amplifier A1 whose other input terminal is connected to earth. A voltage equal to a1*7 volt can therefore be tapped off at the output, a1 being the (variable) gain.

The temperature-dependent voltage source VS2 is formed by a temperature-independent voltage source VS3, for example also the component µA723 mentioned, with a fixed voltage divider, in combination with a temperature-dependent voltage source which is formed by a diode D incorporated in a current circuit supplied by a current source CS; said current source is formed in turn by a voltage source VS4 and a relatively high-resistance resistor R. The fixed voltage divider connected to the temperature-independent voltage source VS3 is adjusted in such a way that its output voltage is equal to the voltage across the diode D, for example 0.7 volts. The APD to be supplied and the diode are sited in such a way that they are exposed to the same ambient temperature, for example mounted on the same printed circuit board; the fixed voltage divider is then also adjusted at a temperature which is equal to the normal operating temperature at which the APD to be supplied operates, normally room temperature. In a subtraction circuit '-', the diode voltage is subtracted from the output voltage of the voltage divider and the resultant voltage difference is presented to the input of an amplifier A2, whose other input is at earth. The output voltage of the voltage divider is, for example, 0.7 volts. The voltage across the diode is also 0.7 volts, increased or decreased by the mathematical product of a temperature constant and the difference between the current temperature and room temperature; the temperature constant is, for example, 2 millivolts per degree Celsius. In that case, the voltage presented to the input of the amplifier A2 is therefore equal to (0.7 + 2 mV/deg) - 0.7 = 2 mV/deg. This voltage is therefore solely dependent on the temperature. It can be amplified by the amplifier A2 by a gain of a 2, with the result that the voltage at the output of the amplifier A2 is equal to a2*2mV/deg. In a voltage adder '+', the output voltages of the first amplifier A1 and that of the second amplifier A2 are added to one another resulting in an output voltage (a1*7 + a2*mV/deg), it therefore being possible to adjust a1 and a2 independently of one another.

## Claims

1. Electrical supply circuit comprising a first, temperature-independent voltage source (VS1) whose output voltage U1 is constant and which is connected to the input of a first voltage amplifier (A1) having a controllable gain (a1), and a second temperature-dependent voltage source (VS2) whose output voltage U2 is essentially equal to the mathematical product of a constant C and the temperature t measured at a measuring point and which is connected to the input of a second voltage amplifier (A2) having a controllable gain (a2), the output voltage of the first voltage amplifier and the output voltage of the second voltage amplifier being added to one another.

2. Electrical supply circuit according to Claim 1, wherein the second, temperature-dependent voltage source (VS2) is formed by a third, temperature-independent voltage source (VS3) having a third, constant output voltage U3 and by a series circuit of a current source (CS) and a temperature-dependent impedance (D), the fourth output voltage U4 generated by said current source (CS) across said temperature-dependent impedance having a temperature independent component equal to the third constant output voltage U3 and a temperature dependent component, the output voltage U2 of said second temperature dependent voltage source (VS2) being obtained by substracting said third constant output voltage from said fourth output voltage.

3. Electrical supply circuit according to Claim 2, wherein said temperature-dependent impedance is formed by a semiconductor diode (D) connected in the forward direction with respect to said current source (CS).

## Patentansprüche

1. Elektrische Speiseschaltung, umfassend eine erste, temperaturunabhängige Spannungsquelle (VS1), deren Ausgangsspannung U1 konstant ist, und die mit dem Eingang eines ersten Spannungsverstärkers (A1) verbunden ist, der einen steuerbaren Verstärkungsfaktor (a1) aufweist, und eine zweite, temperaturabhängige Spannungsquelle (VS2), deren Ausgangsspannung U2 im wesentlichen gleich dem mathematischen Produkt einer Konstante C mit der an einem Messpunkt gemessenen Temperatur t ist, und die mit dem Eingang eines zweiten Spannungsverstärkers (A2) verbunden ist, der einen steuerbaren Verstärkungsfaktor (a2) aufweist, wobei die Ausgangsspannung des ersten Spannungsverstärkers und die Ausgangsspannung des zweiten Spannungsverstärkers miteinander addiert werden.

2. Elektrische Speiseschaltung nach Anspruch 1, wobei die zweite, temperaturabhängige Spannungsquelle (VS2) von einer dritten, temperaturunabhängigen Spannungsquelle (VS3) gebildet ist, die eine dritte, konstante Ausgangsspannung U3 aufweist, sowie von einer Serienschaltung einer Stromquelle (CS) und einer temperaturabhängigen Impedanz (D), wobei die von dieser Stromquelle (CS) durch diese temperaturabhängige Impedanz erzeugte vierte Ausgangsspannung U4 eine temperaturunabhängige Komponente aufweist, die gleich der dritten, konstanten Ausgangsspannung U3 ist, und eine temperaturabhängige Komponente, wobei die Ausgangsspannung U2 dieser zweiten, temperaturabhängigen Spannungsquelle (VS2) erhalten wird, indem diese dritte, konstante Ausgangsspannung von dieser vierten Ausgangsspannung subtrahiert wird.

3. Elektrische Speiseschaltung nach Anspruch 2, wobei diese temperaturabhängige Impedanz von einer Halbleiterdiode (D) gebildet ist, die in bezug auf diese Spannungsquelle (CS) in der Vorwärtsrichtung geschaltet ist.

## Revendications

1. Circuit d'alimentation comprenant : une première source de tension indépendante de la température (VS1) dont la tension de sortie U1 est constante et qui est connectée à l'entrée d'un premier amplificateur de tension (A1) dont le gain (a1) peut être commandé ; et une seconde source de tension dépendante de la température (VS2) dont la tension de sortie U2 est sensiblement égale au produit mathématique d'une constante C et de la température t mesurée au droit d'un point de mesure et qui est connectée à l'entrée d'un second amplificateur de tension (A2) dont le gain (a2) peut être commandé ; la tension de sortie du premier amplificateur de tension et la tension de sortie du second amplificateur de tension étant ajoutées l'une à l'autre.

2. Circuit d'alimentation électrique selon la revendication 1, dans lequel la seconde source de tension dépendante de la température (VS2) est formée par une troisième source de tension indépendante de la température (VS3) ayant une troisième tension de sortie constante U3 et par un circuit en série d'une source de courant (CS) et d'une impédance dépendante de la température (D), la quatrième tension de sortie U4, produite par ladite source de courant (CS), aux bornes de ladite impédance dépendante de la température ayant une composante indépendante de la température égale à une troisième tension de sortie constante U3 et une composante dépendante de la température, la tension de sortie U2 de ladite seconde source de tension dépendante de la température (VS2) étant obtenue en soustrayant ladite troisième tension de sortie constante de ladite quatrième tension de sortie.

3. Circuit d'alimentation électrique selon la revendication 2, dans lequel ladite impédance dépendante de la température est formée par une diode semiconductrice (D) connectée dans le sens direct par rapport à ladite source de courant (CS).
